# EUROPÄISCHE PATENTANMELDUNG

(11) **EP 2 330 648 A1**
(43) Veröffentlichungstag der Anmeldung: **08.06.2011**
(21) Anmeldenummer: 09015050.9
(22) Anmeldetag: 04.12.2009
(51) Int. Cl.: H01L 41/193, H01L 41/26

(54) **Piezoelektrisches Polymerfilmelement, insbesondere Polymerfolie und Verfahren zu dessen Herstellung**

(71) Anmelder: Bayer MaterialScience AG, 51368 Leverkusen (DE)
(72) Erfinder: Jenninger, Werner, Dr., 50677 Köln (DE); Wagner, Joachim, Dr., 51061 Köln (DE); Gerhard, Reimund, Prof. Dr., 10623 Berlin (DE); Wirges, Werner, Dipl. Ing., 14532 Kleinmachnow (DE)

(57) **Zusammenfassung**

Die vorliegende Erfmdung betrifft ein piezoelektrisches Polymerfilmelement (1), insbesondere eine Polymerfolie, umfassend eine Polymermatrix (2) wobei in der Polymermatrix (2) Hohlraumpartikel (4) angeordnet sind, sowie ein Verfahren zur Herstellung eines solchen piezoelektrischen Polymerfilmelements, umfassend die Schritte: A) Bereitstellen von Hohlraumpartikeln (3) und B) Einbringen der Hohlraumpartikel (3) in eine Polymermatrix (2) und C) Formen der Polymermatrix (2) als Polymerfilm. Des weiteren umfasst die Erfmdung einen elektromechanischen Wandler umfassend mindestens einen ersten Polymerfilm (1), welcher Hohlraumpartikel (3) als Füllstoffe umfasst.

## Beschreibung

Die vorliegende Erfmdung betrifft ein piezoelektrisches Polymerfilmelement, insbesondere eine Polymerfolie, umfassend eine Polymermatrix, wobei in der Polymermatrix Hohlraumpartikel angeordnet sind. Die Erfmdung betrifft weiterhin ein Verfahren zur Herstellung solcher Polymerfilmelemente.

Polymere und Polymerverbundstoffe werden bereits in einer Vielzahl von kommerziellen Anwendungen eingesetzt. Funktionspolymere gewinnen dabei in zunehmendem Maße als aktive Komponenten in Sensor- oder Aktoranwendungen an Bedeutung. In den letzten Jahren steht zunehmend eine neue Klasse piezoelektrischer Polymere, die so genannten Ferroelektrete, im Interesse der Forschung. Die Ferroelektrete werden auch Piezoelektrete genannt. Ferroelektrete bestehen aus Polymermaterialien mit einer Hohlraumstruktur, die elektrische Ladungen über lange Zeiträume speichern können. Einige bekannte Ferroelektrete weisen eine zelluläre Hohlraumstruktur auf und sind entweder als geschäumte Polymerfolien oder als Mehrschichtsysteme aus Polymerfolien oder Polymergeweben ausgebildet. Sind elektrische Ladungen entsprechend ihrer Polarität auf den unterschiedlichen Oberflächen der Hohlräume verteilt, stellt jeder geladene Hohlraum einen elektrischen Dipol dar. Werden die Hohlräume nun deformiert, bedingt dies eine Änderung der Dipolgröße und führt zu einem Stromfluss zwischen äußeren Elektroden. Die Ferroelektrete können eine piezoelektrische Aktivität zeigen, die der anderer Piezoelektrika vergleichbar ist.

In der US 4,654,546 ist ein Verfahren zur Herstellung von Polypropylen-Schaumfolien als Vorstufe zu einer Ferroelektretfolie beschrieben. Hierbei werden die Polymerfolien mit Füllstoffpartikeln versetzt. Als Füllstoff wird zum Beispiel Titandioxid eingesetzt. Die Polypropylenfolien werden nach dem Extrudieren biaxial gereckt, so dass sich rund um die Füllstoffpartikel kleine Hohlräume in der Folie ausbilden. Dieses Verfahren wurde inzwischen auch auf andere Polymere angewendet. So wurde zum Beispiel in M. Wegener, M. Paajanen, O. Voronina, R. Schulze, W. Wirges, and R. Gerhard-Multhaupt "Voided cyclo-olefin polymer films: Ferroelectrets with high thermal stability", Proceedings, 12th International Symposium on Electrets (IEEE Service Center, Piscataway, New Jersey, USA 2005), 47-50 (2005) und Eetta Saarimäki, Mika Paajanen, Ann-Mari Savijärvi, and Hannu Minkkinen, Michael Wegener, Olena Voronina, Robert Schulze, Werner Wirges and Reimund Gerhard-Multhaupt "Novel Heat Durable Electromechanical Film: Processing for Electromechanical and Electret Applications", IEEE Transactions on Dielectrics and Electrical Insulation 13, 963-972 (October 2006), die Herstellung von Ferroelektretfolien aus Cyclo-Olefm-Copolymeren (COC) und Cyclo-Olefm-Polymeren (COP) beschrieben. Die geschäumten Polymerfolien haben den Nachteil, dass sich eine breite Verteilung der Bläschengröße ergeben kann. Dadurch können bei dem anschließenden Aufladungsschritt nicht alle Blasen gleichmäßig gut aufgeladen werden.

Ein weiteres Verfahren zur Herstellung geschäumter Ferroelektret-Polymerfolien ist das direkte physikalische Schäumen einer homogenen Folie mit superkritischen Flüssigkeiten, zum Beispiel mit Kohlendioxid. In Advanced Functional Materials 17, 324-329 (2007), Werner Wirges, Michael Wegener, Olena Voronina, Larissa Zirkel, and Reimund Gerhard-Multhaupt "Optimized preparation of elastically soft, highly piezoelectric, cellular ferroelectrets from nonvoided poly(ethylene terephthalate) films", und in Applied Physics Letters 90, 192908 (2007), P. Fang, M. Wegener, W. Wirges, and R. Gerhard L. Zirkel "Cellular polyethylene-naphthalate ferroelectrets: Foaming in supercritical carbon dioxide, structural and electrical preparation, and resulting piezoelectricity", ist dieses Verfahren mit Polyestermaterialien, sowie in Applied Physics A: Materials Science & Processing 90, 615-618 (2008), O. Voronina, M. Wegener, W. Wirges, R. Gerhard, L. Zirkel, and H. Münstedt "Physical foaming of fluorinated ethylene-propylene (FEP) copolymers in supercritical carbon dioxide: single film fluoropolymer piezoelectrets" für ein Fluorpolymer FEP (Fluorinated Ethylene-Propylene Copolymer) beschrieben worden.

In den Veröffentlichungen von X. Zhang, J. Hillenbrand und G. M. Sessler, "Thermally stable fluorocarbon ferroelectrets with high piezoelectric coefficient". Applied Physics A, Vol. 84, pp. 139-142, 2006 und "Ferroelectrets with improved thermal stability made from fused fluorocarbon layers", Journal of Applied Physics, Vol. 101, paper 054114, 2007, sowie in Xiaoqing Zhang, Jinfeng Huang and Zhongfu Xia "Piezoelectric activity and thermal stability of cellular fluorocarbon films" PHYSICA SCRIPTA Vol. T129 pp 274-277, 2007 ist die Strukturierung der Polymerschichten durch Aufdrücken eines Metallgitters auf einen Polymerschichtstapel aus mindestens drei in alternierender Reihenfolge übereinander gelagerten FEP- und PTFE-Schichten beschrieben. Durch das Zusammenpressen der Schichten durch das Gitter bei einer Temperatur, die über dem Schmelzpunkt von FEP und unter dem von PTFE liegt, werden die Polymerschichten entsprechend der Gitterstruktur derart miteinander verbunden, dass sich zwischen den Gitterstäben kuppelförmige oder blasenförmige Hohlräume mit rechteckiger Grundfläche bilden. Dieses Verfahren führt jedoch zu Ferroelektreten mit unterschiedlicher Qualität, da die Bildung gleichförmiger Hohlräume vor allem bei zunehmender Schichtenanzahl nur schwer kontrolliert werden kann.

Ein anderes Verfahren zur Herstellung blasenförmiger Hohlräume unter Verwendung eines Gitters ist durch R. A. C. Altafim, H. C. Basso, R. A. P. Altafim, L. Lima, C. V. De Aquino, L. Gonalves Neto and R. Gerhard-Multhaupt, in "Piezoelectrets from thermo-formed bubble structures of fluoropolymer-electret films", IEEE Transactions on Dielectrics and Electrical Insulation, Vol. 13, No.5, pp. 979-985, 2006 beschrieben worden. Hierbei werden zwei übereinander angeordnete Teflon-FEP-Folien zwischen einem Metallgitter und einem oberen zylinderförmigen Metallteil angeordnet. Dieser Aufbau wird mit dem Metallgitter auf ein unteres zylinderförmiges Metallteil aufgepresst, welches Öffnungen zur Anlegung eines Vakuums aufweist. Die FEP-Folien werden durch das obere Metallteil erhitzt und durch ein an das untere Metallteil angelegtes Vakuum wird die untere Folie in die Öffnungen des Gitters gezogen und entsprechende Hohlräume gebildet. Die beschriebenen Verfahren unter Verwendung eines Gitters zur Ausbildung von Hohlräumen in den Polymer-Mehrschichtverbunden sind aufwendig und schwierig in den großtechnischen Maßstab zu übertragen.

Piezoelektretrische Materialien sind für kommerzielle Anwendungen, beispielsweise für Sensor-, Aktor- und Generatorsysteme, weiterhin von zunehmendem Interesse. Für die Wirtschaftlichkeit ist dabei eine Anwendbarkeit eines Herstellungsverfahrens im industriellen Maßstab essentiell.

Der Erfmdung liegt daher die Aufgabe zu Grunde, neue alternative Piezoelektret-Materialien sowie alternative Verfahren zur Herstellung solcher Piezoelektret-Materialien bereitzustellen, mit denen definierte Piezoelektret-Hohlraumstrukturen erzeugt werden können und die einfach und kostengünstig auch im großtechnischen und industriellen Maßstab durchführbar sind.

Erfindungsgemäß wird ein piezoelektrisches Polymerfilmelement, insbesondere eine Polymerfolie vorgeschlagen, welches eine Polymermatrix umfasst, wobei in der Polymermatrix Hohlraumpartikel angeordnet sind. Mit anderen Worten wird erfindungsgemäß ein Film aus Polymermaterial bereitgestellt, welcher Hohlraumpartikel als Füllstoffe enthält.

Unter einem "Hohlraumpartikel" kann insbesondere ein Partikel verstanden werden, welcher vor dem Einbringen in die Polymermatrix eine definierte Form und ein darin eingeschlossenes definiertes Hohlraum-Volumen aufweist. Vorzugsweise bleibt diese Form bis zum Abschluss der Herstellung des erfindungsgemäßen piezoelektrischen Polymerfilmelements im Wesentlichen erhalten. Vorteilhafterweise kann so die Hohlraumstruktur, insbesondere die Form und Größe der Hohlräume selbst, genau vorbestimmt werden. Die Hohlraumpartikel können beispielsweise eine sphärolitische oder längliche Form aufweisen. Das Hohlraumvolumen in den erfindungsgemäßen Polymerfilmelementen, insbesondere Polymerfolien, kann vorteilhafterweise genau durch die Größe und die Dichte der Hohlraumpartikel, beispielsweise die Anzahl der Hohlraumpartikel pro Flächeneinheit eines Polymerfilms, bestimmt werden. Die Verteilung der Hohlraumpartikel, das heißt der mittlere (maximale) Abstand der Hohlraumpartikel zueinander, kann entsprechend der gewünschten Eigenschaften der Polymerfilmelemente geeignet gewählt werden.

In einer Ausführungsform der Erfmdung können die Hohlraumpartikel in Form von hohlen Kugeln, und/oder hohlen Strängen (Schläuchen) ausgebildet sein. Vorzugsweise weisen die Hohlraumpartikel eine möglichst geringe Größenverteilung auf. Insbesondere können die Hohlraumpartikel nicht nur im Wesentlichen die gleiche Höhe, sondern auch einen im Wesentlichen gleich großen Durchmesser der Hohlräume aufweisen. Unter der Höhe der Hohlraumpartikel wird dabei die (äußere) Höhe in Richtung der Dicke des Polymerfilms verstanden. Dabei kann unter "im Wesentlichen die gleiche Höhe" und "einen im Wesentlichen gleich großen Durchmesser" verstanden werden, dass die Hohlraumpartikel im Rahmen der Produktionstoleranz, beispielsweise von weniger als 5 %, insbesondere von weniger als 1 %, die gleiche Höhe und/oder den gleichen Durchmesser aufweisen. Sind die Hohlraumpartikel in einem Polymerfilmelement möglichst einheitlich in ihrer Größe und Geometrie ausgefiihrt, können die weiteren Bedingungen und Eigenschaften für das piezoelektrische Polymerfilmelement, wie zum Beispiel ein Polungsprozeß oder die Einstellung der Resonanzfrequenz vorteilhafterweise besonders gut optimiert werden. Die Größe, insbesondere die Höhe und/oder der Durchmesser, der Hohlraumpartikel wird im Verhältnis zur Dicke der Polymermatrix vorzugsweise derart eingestellt, dass die Polymermatrix die Hohlraumpartikel vollständig umgibt. Insbesondere kann die als Polymerfilm ausgebildete Polymermatrix durchgehende ebene Oberflächen aufweisen.

Der Volumenanteil der Hohlraumpartikeln kann im Verhältnis zur Polymermatrix erfindungsgemäß ≥10 Vol.-%, bevorzugt ≥15 Vol.-% mehr bevorzugt ≥20 Vol.-%, betragen. Erfindungsgemäß sind jedoch auch größere Volumenanteile der Hohlraumpartikel im Verhältnis zur Polymermatrix, beispielsweise ≥50 Vol.-%, oder sogar ≥60 Vol.-% ,der Hohlraumpartikel möglich. Die Volumenanteile der Hohlraumpartikel und der Polymermatrix ergänzen sich erfindungsgemäß jeweils zu 100 Vol.%

Die Größe, insbesondere die Höhe und/oder der Durchmesser, der Hohlraumpartikel kann vorzugsweise derart ausgewählt werden, dass nach Fertigstellung des erfindungsgemäßen piezoelektrischen Polymerfilmelements das resultierende Gesamthohlraumvolumen möglichst groß ist. Beispielsweise können die Hohlraumpartikel eine Höhe von ≥1 µm bis ≤800 µm, insbesondere von ≥2 µm bis ≤300 µm, insbesondere von ≥5 µm bis ≤100 µm und/oder einen Durchmesser von ≥1 µm bis ≤00 µm, insbesondere von ≥2 µm bis ≤300 µm, insbesondere ≥5 µm bis ≤100 µm aufweisen. Vorzugsweise sind die Hohlraumpartikel aus einem im Wesentlichen elektrisch nicht leitenden und/oder elektrisch nicht polarisierbaren Material ausgebildet.

Die Hohlraumpartikel können sowohl homogen als auch heterogen verteilt in der Polymermatrix angeordnet sein. Insbesondere können die Hohlraumpartikel homogen verteilt angeordnet sein. In Abhängigkeit von einem speziellen Anwendungsbereich für ein erfindungsgemäßes piezoelektrisches Polymerfilmelement und gegebenenfalls damit herzustellenden elektromechanischen Wandlers, kann es jedoch auch vorteilhaft sein, die Hohlraumpartikel, insbesondere gezielt, ortsaufgelöst heterogen verteilt anzuordnen.

Weiterhin können die in der Polymermatrix angeordneten Hohlraumpartikel in weniger bevorzugten Ausführungsformen in gleichen oder unterschiedlichen Formen ausgebildet sein. Insbesondere kann eine Vielzahl an in einer ersten Form ausgebildeten Hohlraumpartikeln und eine Vielzahl an in einer zweiten Form ausgebildeten Hohlraumpartikeln und gegebenenfalls eine Vielzahl an in einer dritten Form ausgebildeten Abstandselementen, et cetera, in der Polymermatrix angeordnet sein. Dabei können die in unterschiedlichen Formen ausgebildeten Hohlraumpartikel wiederum homogen oder heterogen verteilt angeordnet sein. Insbesondere können die elektromechanischen, insbesondere piezoelektrischen, Eigenschaften des erfindungsgemäß bereitgestellten piezoelektrischen Polymerfilmelements durch Auswahl der Hohlraumpartikelform, Hohlraumpartikelanordnung und/oder Hohlraumpartikelverteilung angepasst werden.

Die Hohlraumpartikel können grundsätzlich, gegebenenfalls unabhängig voneinander, aus jedem Material ausgebildet sein, welches geeignet ist, einen Polungsprozess in den Hohlräumen zu ermöglichen und die nach dem Aufladungsprozess gebildeten Ladungen zu separieren und zu speichern.

In einer weiteren Ausführungsform des erfindungsgemäßen piezoelektrischen Polymerelements können die Hohlraumpartikel aus Glas oder einem Polymer oder auch einem im Wesentlichen elektrisch nicht-leitenden, nicht elektrisch polarisierbaren keramischen Material ausgebildet sein. Zum Beispiel können die Hohlraumpartikel aus Mineralglas, insbesondere Kieselglas oder Quarzglas, ausgebildet sein. Polymere zur Ausbildung von erfindungsgemäßen Hohlraumpartikeln können fast beliebig gewählt werden. Vorzugsweise werden Polymermaterialien für die Hohlraumpartikel gewählt, die gute Ladungsspeicher sind und gute Elektreteigenschaften aufweisen. Exemplarisch seien als solche polymere Materialien Polycarbonate, perfluorierte oder teilfluorierte Polymere und -Copolymere wie PTFE, Fluorethylenpropylen (FEP), Perfluoralkoxyethylenen (PFA), Polyester, wie Polyethylenterephthalat (PET) oder Polyethylennaphthalat (PEN), Cyclo-Olefin-Polymere, Cyclo-Olefm-Copolymere, Polyimide, insbesondere Polyetherimid, Polyethern, Polymethylmethacrylat und Polypropylen oder Polymerblends hieraus genannt. Mit diesen Materialien können gute bis sehr gute Piezoaktivitäten erzielt werden. Die erfindungsgemäß breite Materialauswahl kann vorteilhafterweise auch eine Anpassung auf bestimmte Anwendungen ermöglichen.

Insbesondere können die Hohlraumpartikel in Form von Glaskugeln und/oder Polymerkugeln und/oder Glassträngen und/oder Polymersträngen und/oder keramischen Kugeln und/oder Strängen ausgebildet sein.

In einer Ausgestaltung des erfindungsgemäßen piezoelektrischen Polymerfilmelements kann die Polymermatrix aus einem elektrisch nicht-leitenden Polymeren oder elektrisch nicht-leitenden Polymermischung, insbesondere aus einem Elastomer bestehen, wobei nicht-leitend erfindungsgemäß bedeutet, dass das Polymer einen ausreichend hohen elektrischen Widerstand aufweist, um einen geeigneten Polungsprozeß zu ermöglichen. Die Polymermatrix kann in einer bevorzugten Ausführungsform aus einem Polyurethan-Elastomer, Silikon-Elastomer, Acrylat-Elastomer, oder Kautschuk oder einer Mischung hieraus bestehen. Mit diesen vergleichsweise weichen Materialien können besonders hohe piezoelektrische Konstanten des erfindungsgemäßen Polymerfilmelements erzielt werden. Die Steifigkeit der Polymermatrix kann erfmdungsgemäß vorteilhafterweise gezielt auf spezielle Anforderungen und/oder Anwendungen angepasst werden.

Die Polymermatrix kann erfindungsgemäß aus jedem Material ausgebildet sein, welches geeignet ist, einen Polungsprozess zu ermöglichen und die nach dem Aufladungsprozess in den in den Hohlräumen gebildeten Ladungsschichten zu separieren und zu speichern. Beispielsweise kann die Polymermatrix aus mindestens einem Polymer ausgewählt aus der Gruppe bestehend aus vorzugsweise elastomeren Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharzen, Phenoxyharzen, Polyolefinen, Polyvinylchlorid, Polyvinylestern, Polyvinylalkoholen, Polyvinylacetalen, Polyvinylethern, Polyacrylaten, Polymetacrylaten, Polystyrolen Polycarbonaten, Polyestern, Copolyestern, Polyamiden, Silikonharzen, Polyurethanen, insbesondere Ein- oder Zweikomponenten- Polyurethanharzen oder Silikonharzen, und Mischungen der genannten Polymere, insbesondere als Bindemittel, ausgebildet sein.

In einer anderen Ausgestaltung kann die Polymermatrix des erfindungsgemäßen piezoelektrischen Polymerfilmelements, insbesondere einer Polymerfolie, eine Dicke (D) von ≥5 µm bis ≤1000 µm, bevorzugt von ≥10 µm bis ≤500 µm, beispielsweise von ≥20 µm bis ≤50 µm aufweisen.

Die Erfmdung betrifft weiterhin ein Verfahren zur Herstellung eines piezoelektrischen Polymerelements, umfassend die Schritte:
A) Bereitstellen von Hohlraumpartikeln und
B) Einbringen der Hohlraumpartikel in eine Polymermatrix
C) Formen der Polymermatrix zum Polymerfilm.

Geeignete Hohlraumpartikel aus Polymeren können beispielsweise durch Umgeben eines Treibmittels, zum Beispiel Isobutan oder Isopropan, mit einem ausgewählten Polymermaterial und anschließender kontrollierter Erwärmung erzeugt werden. Für keramische Materialien besteht die Möglichkeit so genannte Porenbildner für die Bildung der Hohlräume in den Partikeln zu verwenden, die, beispielsweise in einem Sinterprozess, rückstandsfrei entfernt werden können. Alternativ sind geeignete Hohlraumpartikel, beispielsweise Glashohlkugeln von der Firma 3M, kommerziell erhältlich. Zum Beispiel sind die Glashohlkugeln 3M™ Glass Bubbles K1, 3M™ Glass Bubbles K15, 3M™ Glass Bubbles S38, oder 3M™ Glass Bubbles S60 erfindungsgemäß geeignet.

Das Einbringen der Hohlraumpartikel in die Polymermatrix kann beispielsweise durch Einmischen in das Polymermaterial, beispielsweise in ein Granulat eines thermoplastischen Materials, das nachfolgend aufgeschmolzen wird, oder schon aufgeschmolzenes Polymermaterial, erfolgen aus dem die Polymermatrix gebildet wird. Nachfolgend kann dann das Polymermaterial für die Polymermatrix mit den darin verteilten Hohlraumpartikeln verfestigt, beispielsweise getrocknet und/oder vernetzt und/oder erstarrt werden. Dies kann beispielsweise thermisch, durch Bestrahlen mit ultraviolettem Licht, durch Bestrahlen mit Infrarotlicht und/oder durch Trocknen erfolgen.

Beispielsweise können die vorgesehenen Hohlraumpartikel mit einer ersten Komponente eines Zweikomponenten-Silikonharzes gemischt werden und zu dieser Mischung kann nachfolgend die zweite Komponente des Silikonharzes zugefügt und wiederum gemischt werden. Die Polymermaterialmischung mit den eingemischten Hohlraumpartikeln kann dann formgebend, beispielsweise zu einem Polymerfilm weiterverarbeitet werden.

Das Polymermaterial kann beispielsweise auch in gelöster Form oder mit Lösungsmittel versetzt bereitstellt werden, so dass die Hohlraumpartikel in eine Polymermaterial-Lösung oder durch Lösungsmittel ausreichend erweichtes Polymermaterial eingebracht werden. Nachfolgend kann durch Trocknen, also Entfernen des Lösungsmittels, die Verfestigung des Polymermaterials mit den eingebrachten Hohlraumpartikeln erfolgen. Das Trocknen kann beispielsweise durch Abdampfen lassen bei Raumtemperatur durchgeführt werden. Es kann aber auch thermisch und/oder unter zu Hilfenahme eines Luftstroms unterstützt und beschleunigt erfolgen.

In Schritt C) des Verfahrens kann zur Herstellung des erfindungsgemäßen Polymerfilmelements die Polymermatrix aus einem Polymermaterial als Polymerfilm gebildet und/oder geformt werden. Das aus dem Verfahren resultierende Produkt, also das Polymerfilmelement, kann eine Polymerfolie sein, die Hohlraumpartikel als Füllstoffe enthält.

In einer Ausführungsform kann in Schritt C) des Verfahren die Bildung und/oder Formung des Polymerfilmelements aus dem Polymermaterial mit den eingebrachten Hohlraumpartikeln durch Extrusion oder durch Resin Injektion Moulding, erfolgen.

Bei thermoplastischen Polymermaterialien kommen auch andere bekannte thermoplastische Verarbeitungsverfahren, wie Spritzgießen, zur Formgebung des Polymermaterials zum Polymerfilm in Betracht.

Gleichermaßen kann die Bildung des Polymerelements, insbesondere eines erfindungsgemäßen Polymerfilms durch filmbildende Verfahren, wie sie auch aus der Lackapplikation bekannt sind, beispielsweise auf ein Substrat und gegebenenfalls nachfolgender Ablösung des Polymerfilms vom Substrat, erfolgen. Beispiele für solche Prozesse sind Rakeln, Lackschleudern (Spincoating), Tauchlackieren (Dipcoating), Sprühlackieren (Spraycoating), Vorhanggießen (Curtaincoating), Düsenauftrag (Slot-dye-coating), und/oder auch Walzenauftragsverfahren, beispielsweise mit Walzenauftragswerken für Hotmelt-Klebstoffe von der Firma Hardo Maschinenbau GmbH (Bad Salzuflen, Deutschland).

Die Erfmdung umfasst ebenfalls, dass die Polymermatrix, beispielsweise durch ein oben genanntes filmbildendes Verfahren, beispielsweise durch Lackschleudern, direkt auf eine Elektrode aufgebracht wird, so dass vorteilhafterweise eine nachfolgende Ablösung des entstandenen Polymerfilms entfallen kann. Die Elektrode kann zum Beispiel ein Metallplättchen sein.

Erfindungsgemäß kann in einer Ausgestaltung des Verfahrens das Polymermaterial zur Bildung der Polymermatrix mindestens ein Polymer, vorzugsweise ein elastomeres Polymermaterial, ausgewählt aus der Gruppe bestehend aus Kautschuk, Kautschukderivaten, ungesättigten Polyestern, Alkydharzen, Phenolharzen, Aminoharzen, Amidoharzen, Ketonharzen, Xylol-Formaldehydharzen, Epoxidharzen, Phenoxyharzen, Polyolefinen, Polyvinylchlorid, Polyvinylestern, Polyvinylalkoholen, Polyvinylacetalen, Polyvinylethern, Polyacrylaten, Polymetacrylaten, Polystyrolen, Polycarbonaten, Polyestern, Copolyestern, Polyamiden, Silikonharzen, Polyurethanen und Mischungen dieser Polymere, umfassen. Insbesondere können Ein- oder Zweikomponenten Silikonharze oder Ein- oder Zweikomponenten Polyurethane als Polymermaterial für die Polymermatrix eingesetzt werden.

In einer erfindungsgemäßen Verfahrensausgestaltung kann in einem Schritt D) die Aufladung des Polymerfilmelements mit entgegengesetzten elektrischen Ladungen erfolgen. Insbesondere werden durch Anlegen eines hohen elektrischen Feldes Dipole in den Hohlräumen der Partikel erzeugt.

In einer weiteren Ausführungsform des Verfahrens nach der Erfindung kann als Schritt E) die Aufbringung von Elektroden auf die Oberflächen des Polymerfilmelements, insbesondere einer Polymerfolie, umfasst sein.

Im Rahmen der vorliegenden Erfmdung kann sowohl erst Verfahrensschritt D) und dann Verfahrensschritt E) als auch erst Verfahrensschritt E) und dann Verfahrensschritt D) durchgeführt werden.

Das Aufladen in Schritt D) kann beispielsweise durch direkte Aufladung, das heißt Anlegen eines hohen elektrischen Feldes, Anlegen einer elektrischen Spannung an die Elektroden oder durch Coronaentladung erfolgen. Insbesondere kann das Aufladen durch eine Zweielektroden-Corona-Anordnung erfolgen. Dabei kann die Nadelspannung mindestens ≥10 kV, beispielsweise mindestens ≥25 kV, insbesondere mindestens ≥30 kV, betragen. Die Aufladezeit kann dabei mindestens ≥20 s, beispielsweise mindestens ≥30 s, insbesondere mindestens ≥1 min, betragen.

Die Elektroden können in Schritt E) mittels dem Fachmann bekannter Verfahren auf das Polymerfilmelement aufgebracht werden. Hierfür kommen beispielsweise Verfahren wie beispielsweise die physikalische Gasphasenabscheidung (englisch: Physical Vapor Deposition, (PVD)), Sputtern, und/oder Aufdampfen, die chemische Gasphasenabscheidung (englisch: Chemical Vapor Deposition, (CVD)), Drucken, Rakeln, Spin-Coaten in Frage. Die Elektroden können auch in vorgefertigter Form aufgeklebt werden.

Bei den Elektrodenmaterialien kann es sich um dem Fachmann bekannte leitfähige Materialien handeln. Hierfür kommen beispielsweise Metalle, Metall-Legierungen, Halbleiter, leitfähige Oligo- oder Polymere, wie Polythiophene, Polyaniline, Polypyrrole, leitfähige Oxide oder Mischoxide, wie Indiumzinnoxid (ITO), oder mit leitfähigen Füllstoffen gefüllte Polymere in Frage. Als Füllstoffe für mit leitfähigen Füllstoffen gefüllte Polymere kommen beispielsweise Metalle, wie Silber, Aluminium und/oder Kupfer, leitfähige Kohlenstoff basierende Materialien, beispielsweise Ruß, Kohlenstoffnanoröhrchen (Carbonanotubes (CNTs)), Graphene oder leitfähige Oligo- oder Polymere, in Frage. Der Füllstoffgehalt der Polymere liegt dabei vorzugsweise oberhalb der Perkolationsschwelle, welche **dadurch gekennzeichnet ist, dass** die leitfähigen Füllstoffe durchgehende elektrisch leitfähige Pfade ausbilden.

Vorteilhafterweise sind alle Prozeßschritte des erfindungsgemäßen Herstellungsverfahrens mindestens teilweise automatisierbar.

Die Elektroden können im Rahmen der vorliegenden Erfmdung auch strukturiert sein. Beispielsweise können die Elektroden derart strukturiert sein, dass das piezoelektrische Polymerelement aktive und passive Bereiche aufweist. Insbesondere können die Elektroden derart strukturiert sein, dass, insbesondere im Sensor-Modus, die Signale ortsaufgelöst detektiert und/oder, insbesondere im Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

Die Erfmdung betrifft weiterhin einen elektromechanischer Wandler, umfassend mindestens einen ersten Polymerfilm, welcher Hohlraumpartikel als Füllstoffe umfasst.

Vorzugsweise umfasst ein erfindungsgemäßer elektromechanischer Wandler mindestens einen erfindungsgemäßen piezoelektrischen Polymerfilm. Weiterhin kann dieser mindestens zwei Elektroden, insbesondere Elektrodenschichten umfassen, wobei eine Elektrode die erste Oberfläche des Polymerfilms und die andere Elektrode die zweite Oberfläche des Polymerfilms kontaktiert.

Hinsichtlich weiterer Merkmale eines erfindungsgemäßen elektromechanischen Wandlers wird hiermit explizit auf die Erläuterungen im Zusammenhang mit dem erfindungsgemäßen Verfahren und der erfindungsgemäßen Verwendung verwiesen.

Ein weiterer Gegenstand der vorliegenden Erfmdung ist die Verwendung eines erfindungsgemäßen piezoelektrischen Polymerfilmelements oder elektromechanischen Wandlers als Sensor, Generator und/oder Aktuator, beispielsweise im elektromechanischen und/oder elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie, insbesondere in Lautsprechern, Schwingungswandlem, Lichtdeflektoren, Membranen, Modulatoren für Glasfaseroptik, pyroelektrischen Detektoren, Kondensatoren und Kontrollsystemen.

Hinsichtlich weiterer Merkmale einer erfindungsgemäßen Verwendung wird hiermit explizit auf die Erläuterungen im Zusammenhang mit dem erfindungsgemäßen Verfahren und dem erfindungsgemäßen Polymerelement sowie dem erfindungsgemäßen elektromechanischen Wandler verwiesen.

Die Erfmdung wird nachfolgend in beispielhafter Weise in Verbindung mit den Figuren erläutert ohne auf diese Ausführungsformen beschränkt zu sein.

Es zeigen:
- Fig. 1: einen schematischen Querschnitt durch eine erste Ausführungsform eines erfindungsgemäßes Polymerfilmelement.
- Fig. 2: einen schematischen Querschnitt durch eine andere Ausführungsform eines erfindungsgemäßes Polymerfilmelements nach der Polung.

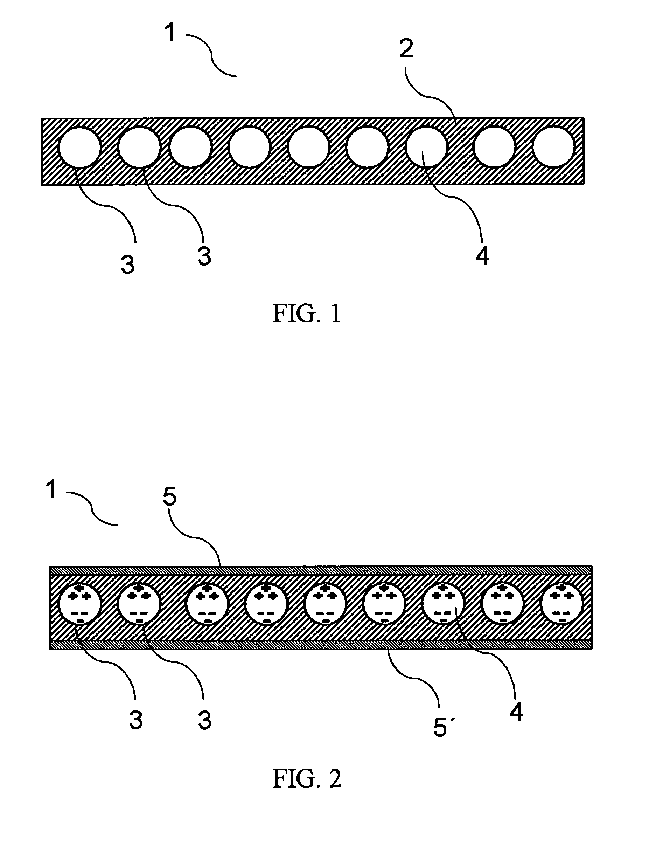

Figur 1 zeigt einen schematischen Querschnitt durch eine erste Ausführungsform eines erfindungsgemäßes piezoelektrisches Polymerfilmelement 1, welches eine Polymermatrix 2 und darin angeordnete Hohlraumpartikel 3 mit darin eingeschlossenen Hohlräumen 4 umfasst. Der Übersichtlichkeit halber sind nur neun Hohlraumpartikel 3 in einer Lage gezeigt. Die Erfmdung soll hierdurch nicht eingeschränkt werden. Die Hohlraumpartikel 3 können erfindungsgemäß auch statistisch verteilt, in mehreren Lagen, versetzt zueinander und/oder übereinander in der Polymermatrix 2 angeordnet sein. Die Hohlraumpartikel 3 sind als hohle Kugeln ausgestaltet und weisen im Wesentlichen die gleiche Höhe und im Wesentlichen den gleichen Durchmesser auf. Dabei bedeutet "im Wesentlichen" insbesondere, dass fertigungsbedingte Größen und/oder Höhenunterschiede umfasst sind. Im Rahmen der gezeigten, ersten Ausführungsform des erfindungsgemäßen piezoelektrischen Polymerfilmelements 1 kann die Polymermatrix 2 aus einem elastomeren Polymermaterial ausgebildet sein. Die Hohlraumpartikel 3 können dabei vorzugsweise aus einem elektrisch nicht-leitenden und nicht-polarisierbaren Material, beispielsweise aus Glas, einem polymeren Material oder einem keramischen Material ausgebildet sein und können vor der endgültigen Formgebung der Polymermatrix zu einem Polymerfilm, beispielsweise durch Extrusion des gewählten Polymermaterials in das Polymermaterial eingemischt werden.

Figur 2 zeigt einen schematischen Querschnitt durch eine weitere Ausgestaltung des erfindungsgemäßen Polymerfilmelements 1 aus Figur1. Auf die Oberflächen der Polymermatrix 2 sind Elektroden 5, 5' flächig aufgebracht. Die Aufbringung der Elektroden 5, 5' kann beispielsweise durch physikalische Gasphasenabscheidung, Sputtern, und/oder Aufdampfen, chemische Gasphasenabscheidung, Drucken, Rakeln, Spin-Coaten oder durch Aufkleben vorgefertigter Elektroden erfolgen. Das Polymerfilmelement 1 ist in dieser Ausführungsform bereits gepolt, dass heißt die Hohlräume 4 der Hohlraumpartikel 3 sind mit entgegengesetzten elektrischen Ladungen aufgeladen. Die Polung kann beispielsweise durch eine Corona-Entladung erfolgen. Vorteilhafterweise sind alle Prozeßschritte des erfindungsgemäßen Herstellungsverfahrens mindestens teilweise automatisierbar.

Durch das nachfolgend aufgeführte Beispiel soll die Erfmdung weiter erläutert werden, ohne auf dieses beschränkt zu sein.

### Beispiel 1

Herstellung eines piezoelektrischen Polymerfilmelements aus einer weichen elastischen Polymermatrix und darin eingebrachten Glashohlkugeln als Füllstoff.

Als Polymermatrixmaterial wurde das Wacker Elastosil RV 625 verwendet. Das Wacker Elastosil Material ist ein Zweikomponenten Silikonharz-System. Das Mischungsverhältnis der Komponente A zur Komponente B war bei dem verwendeten Wacker Elastosil A : B = 9 : 1, bezogen auf das Volumen.

Als Hohlraumpartikel wurden Glashohlkugeln, nämlich 3M™ Glass Bubbles K1 der Firma 3M eingesetzt. Das Verhältnis Wacker Elastosil Polymermatrix zu Glashohlkugeln war 83 Vol.-% zu 17 Vol.-%, wobei die Volumenanteile von Polymermatrixmaterial und Glashohlkugeln sich jeweils immer zu 100 Vol-% ergänzen.

Zunächst wurden die Glashohlkugeln mit der Komponente A des Elastosil in einem SpeedMixer bei einer Umdrehung von 2700 pro Minute vermischt. Dann wurde die Komponente B des Elastosil dazu gegeben und nochmals für eine Minute im SpeedMixer bei einer Umdrehung von 2700 pro Minute vermischt. Die Materialmischung aus Polymermatrixmaterial und Glashohlkugeln wurde auf Bronzesubstrate aufgeschleudert. Umdrehungszahlen beim Schleudern wurde zwischen 600 und 1000 Umdrehungen pro Minute für 30 bis 120 Sekunden eingestellt. Anschließend wurden die Proben für 24 Stunden bei 80°C in einem Ofen getempert. Die Probe wurde mit einer Nadelspannung von -15 kV Corona ohne Gitter gepolt. Dann wurde der Polymerfilm vom Substrat abgezogen und der piezoelektrische Koeffizient mit der dynamischen Methode bei einer Frequenz von 2 Hz vermessen. Der Piezokoeffizient lag direkt nach dem Polen bei 45 pC/N.

Versuchsaufbau für die mechanische dynamische Messung der d33 Piezokonstanten der hergestellten piezoelektrischen Polymerfilmelemente und Durchführung der Messungen

Für die Messeinrichtung werden grundsätzlich folgende drei Hauptkomponenten benötigt: Krafterzeuger, Kraftmessgerät und Ladungsmessgerät. Als Krafterzeuger wurde ein elektrischer Schwingerreger Typ 4810 von Brüel & Kjær gewählt. Der Schwingerreger ermöglicht es, eine definierte Kraft in Abhängigkeit von der Eingangsspannung auszuüben. Dieser Schwingerreger wurde an einer beweglichen Plattform montiert, deren Position in vertikaler Richtung manuell einstellbar ist. Die Höhenverstellbarkeit des Schwingerregers ist zum Einspannen der Proben notwendig. Außerdem kann damit der statische Vordruck, der für die Messung erforderlich ist, eingestellt werden. Zur Steuerung des Schwingerregers wurde ein Funktionsgenerator DS 345 von Stanford Research Systems in Verbindung mit einem Leistungsverstärker Typ 2718 von Brüel & Kjær benutzt. Als Kraftmessgerät wurde ein Kraftsensor Typ 8435 von Burster verwendet. Der Kraftsensor ist sowohl auf Druck- als auch auf Zugmessungen im Bereich von 0 bis 200 N ausgelegt. Die Krafteinwirkung darf allerdings nur senkrecht erfolgen, so dass keine seitliche Kraftkomponenten oder Drehmomente auf den Sensor einwirken. Um dies zu gewährleisten, wurde der Kraftsensor mit einer zylinderförmigen Druckführungsschiene mit einem darin beinahe reibungslos gleitenden Bolzen aus Edelstahl versehen. Am freien Ende des Bolzens befand sich eine zwei Zentimeter breite polierte Platte, die als Auflagefläche für die Proben diente. Die Signale vom Kraftsensor werden mit einem Modulverstärker Typ 9243 von Burster erfasst und weiter an ein Oszilloskop GOULD 4094 geleitet.
Als Ladungsmessgerät wurde ein Ladungsverstärker Typ 2635 von Brüel & Kjær verwendet. Der Ladungsverstärker ermöglicht es, Ladungen bis zu 0,1 pC zu erfassen. Für die Messung der Oberflächenladung müssen die beiden Seiten der Probe mit dem Ladungsverstärker elektrisch verbunden sein. Der elektrische Kontakt zu der unteren Seite der Probe wird durch die Auflagefläche ermöglicht, die ihrerseits mit dem gesamten Aufbau verbunden ist. Die obere Seite der Probe wurde durch den Druck-Ausübenden Stempel aus Messing mit dem Ladungsverstärker verbunden. Der Stempel wird durch einen Aufsatz aus Plexiglas am Schwingerreger von dem restlichen Aufbau elektrisch isoliert und durch ein Kabel mit dem Ladungsverstärker verbunden. Das Kabel sollte möglichst dünn und weich sein, um mechanische Spannungen und damit Verfälschungen der Meßergebnisse zu vermeiden. Das gemessene Signal wird schließlich vom Ladungsverstärker zum Oszilloskop weitergeleitet. Standardmäßig wurde ein Vordruck von 3 N (statisch) eingestellt und mit einer Amplitude von 1 N (dynamisch) gemessen.

## Patentansprüche

1. Piezoelektrisches Polymerfilmelement (1), insbesondere Polymerfolie, umfassend eine Polymermatrix (2) **dadurch gekennzeichnet, dass** in der Polymermatrix (2) Hohlraumpartikel (3) angeordnet sind.

2. Piezoelektrisches Polymerfilmelement (1) nach Anspruch 1, **dadurch gekennzeichnet, dass** die Hohlraumpartikel (2) in Form von Kugeln und/oder Strängen ausgebildet sind.

3. Piezoelektrisches Polymerfilmelement (1) nach Anspruch 1, wobei die Hohlraumpartikel (2) aus Glas, einem Polymer oder einem keramischen Material ausgebildet sind.

4. Piezoelektrisches Polymerfilmelement (1) nach Anspruch 1, **dadurch gekennzeichnet, dass** die Hohlraumpartikel (2) eine Höhe von ≥1 µm bis ≤800 µm und/oder einen Durchmesser von ≥1 µm bis ≤800 µm aufweisen.

5. Piezoelektrisches Polymerfilmelement (1) nach Anspruch 1, **dadurch gekennzeichnet, dass** die Polymermatrix (2) aus einem elektrisch nicht-leitenden Polymeren oder einer elektrisch nicht-leitenden Polymermischung besteht.

6. Piezoelektrisches Polymerfilmelement (1) nach Anspruch 1, **dadurch gekennzeichnet, dass** die Polymermatrix (2) aus einem Elastomer besteht.

7. Piezoelektrisches Polymerfilmelement (1) nach Anspruch 1, **dadurch gekennzeichnet, dass** die Polymermatrix (2) aus einem Polyurethan-Elastomer, Silikon-Elastomer, Acrylat-Elastomer und/oder Kautschuk oder einer Mischung hieraus besteht.

8. Piezoelektrisches Polymerfilmelement (1) nach Anspruch 1, **dadurch gekennzeichnet, dass** die Polymermatrix eine Dicke (D) von ≥10 µm bis ≤1000 µm aufweist.

9. Verfahren zur Herstellung eines piezoelektrischen Polymerfilmelements (1), insbesondere einer Polymerfolie, umfassend die Schritte:
A) Bereitstellen von Hohlraumpartikeln (3) und
B) Einbringen der Hohlraumpartikel (3) in eine Polymermatrix (3) aus einem Polymermaterial.
C) Formen der Polymermatrix (2) als Polymerfilm.

10. Verfahren nach Anspruch 9 **dadurch gekennzeichnet, dass** in Schritt C) das Formen des Polymerfilms durch Extrusion, Resin Injektion Moulding, Spritzgießen oder durch Rakeln, Lackschleudern, Tauchlackieren, Sprühlackieren, Vorhanggießen oder Düsenauftrag auf ein Substrat und gegebenenfalls nachfolgender Ablösung des Polymerfilms vom Substrat erfolgt.

11. Verfahren nach Anspruch 9, wobei das Polymermaterial mindestens ein Polymer, ausgewählt aus der Gruppe bestehend aus Kautschuk, Kautschukderivaten, ungesättigten Polyestern, Alkydharzen, Phenolharzen, Aminoharzen, Amidoharzen, Ketonharzen, Xylol-Formaldehydharzen, Epoxidharzen, Phenoxyharzen, Polyolefmen, Polyvinylchlorid, Polyvinylestern, Polyvinylalkoholen, Polyvinylacetalen, Polyvinylethern, Polyacrylaten, Polymetacrylaten, Polystyrolen, Polycarbonaten, Polyestern, Copolyestern, Polyamiden, Silikonharzen, Polyurethanen und Mischungen dieser Polymere, umfasst.

12. Verfahren nach Anspruch 9, **dadurch gekennzeichnet, dass** es einen Schritt D) Aufladung des Polymerfilmelements, insbesondere der Hohlräume (4) in den Hohlraumpartikeln (3), mit entgegengesetzten elektrischen Ladungen umfasst.

13. Verfahren nach Anspruch 9, **dadurch gekennzeichnet, dass** es den Schritt E) Aufbringung von Elektroden (5,5') auf die Oberflächen des Polymerfilms umfasst.

14. Elektromechanischer Wandler, umfassend
- mindestens einen ersten Polymerfilm (1), welcher Hohlraumpartikel (3) als Füllstoffe umfasst.

15. Verwendung eines Polymerfilmelements (1) nach Anspruch 1 oder eines elektromechanischen Wandlers nach Anspruch 14 als Sensor, Generator und/oder Aktuator.
